Europäisches Patentamt

European Patent Office

Office européen des brevets

(11) Veröffentlichungsnummer: **0 098 891**
**B1**

(12) **EUROPÄISCHE PATENTSCHRIFT**

(45) Veröffentlichungstag der Patentschrift:
**29.01.86**

(21) Anmeldenummer: **82106254.4**

(22) Anmeldetag: **13.07.82**

(51) Int. Cl.⁴: **H 03 K 3/287**

(54) Phasenteiler mit integrierter Verriegelungsschaltung.

(43) Veröffentlichungstag der Anmeldung:
**25.01.84 Patentblatt 84/4**

(45) Bekanntmachung des Hinweises auf die Patenterteilung:
**29.01.86 Patentblatt 86/5**

(84) Benannte Vertragsstaaten:
**DE FR GB**

(56) Entgegenhaltungen:
**US - A - 3 987 315**
**US - A - 4 053 873**

**IBM TECHNICAL DISCLOSURE BULLETIN, Band 20, Nr. 4, September 1977, Seiten 1426-1429, New York, USA, H.O. ASKIN et al.: "Latched inverter buffer circuit"**
**IBM TECHNICAL DISCLOSURE BULLETIN, Band 23, Nr. 1, Juni 1980, Seiten 330-331, New York, USA, P.T. MARINO: "Differentially operated latches"**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Klein, Wilfried, Dipl.-Ing., Ulmenstrasse 86, D-7031 Holzgerlingen (DE)**
Erfinder: **Klink, Erich, Dipl.-Ing., Max-Eyth-Strasse 34, D-7036 Schönaich (DE)**
Erfinder: **Najmann, Knut, Dipl.-Ing., Sonnenhalde 15, D-7031 Gärtringen (DE)**
Erfinder: **Wernicke, Friedrich, Dipl.-Ing., Herdlauchring 6, D-7036 Schönaich (DE)**

(74) Vertreter: **Gaugel, Heinz, Dipl.-Ing., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Phasenteiler mit integrierter Verriegelungsschaltung, enthaltend einen über einen ersten taktgesteuerten Schalter an eine Stromversorgung angeschlossenen und in Abhängigkeit von einem Eingangssignal komplementäre Ausgangssignale liefernden Echt-Komplement-Generator, an dessen Ausgänge jeweils eine gesonderte Ausgangsstufe angeschlossen ist.

In ihrer einfachsten Form bestehen Phasenteiler aus einem Inverter, der den invertierten Wert des Eingangssignals liefert, während der nicht invertierte Wert durch eine direkte Verbindung des Eingangs mit dem entsprechenden Ausgang geliefert wird. Die zahlreichen veröffentlichten und patentierten Abwandlungen dieser Grundform zeigen, dass zur Lösung neu anstehender Probleme verschiedenste Verbesserungen und Verfeinerungen erforderlich sind. So ist die blosse Erzeugung des invertierten oder komplementären und des nicht invertierten oder echten Ausgangssignals (was gleichbedeutend ist mit der Erzeugung eines gleich- und eines gegenphasigen Signals) aus einem vorgegebenen Eingangssignal häufig nicht alleine ausreichend, um die angestrebten qualitativen Eigenschaften des Phasenteilers zu gewährleisten. Die Forderungen nach erhöhter Geschwindigkeit, reduziertem Leistungsverbrauch und exakten zeitlichen Beziehungen zwischen den einzelnen Signalen in der Schaltung machen es häufig notwendig, neue verbesserte Schaltungen und Betriebsarten zu entwickeln. Bei der Herstellung der Schaltungen in integrierter Technologie besteht die zusätzliche Forderung, dass sich die Schaltung mit minimalem Platzaufwand in einem Halbleiterkörper verwirklichen lässt.

Bistabile Schaltungen, beispielsweise in Form von Flipflops, sind ebenfalls in grosser Anzahl bekannt und finden verbreitete Anwendung. Dazu zählen auch die Verriegelungsschaltungen. Die Wirkungsweise derartiger Schaltungen besteht im Prinzip darin, dass einem Eingang ein Setzsignal zugeführt wird, aufgrund dessen dann am Ausgang ein gleichphasiges oder gegenphasiges Ausgangssignal erzeugt wird. Dieses Ausgangssignal bleibt aufgrund der Rückkopplungs- oder Verriegelungsfunktion bestehen, auch wenn das Setzsignal inzwischen vom Eingang abgeschaltet ist. Das Ausgangssignal, d.h. also der Schaltzustand der Schaltung, bleibt so lange erhalten, bis einem Rückstelleingang ein Rückstellsignal zugeführt wird. Bei den bekannten Schaltungen dieser Art gilt grundsätzlich, dass das Ausgangssignal gegenüber dem den Schaltvorgang auslösenden Eingangssignal zeitverzögert ist. Die Grösse dieser Schaltverzögerung ergibt sich aus der Zeitdauer des Verriegelungs- bzw. Umschaltvorganges der Schaltung selbst. In Hochgeschwindigkeitsschaltungen dieser Art sind diese Zeitverzögerungen vielfach unerwünscht oder sogar unzulässig.

So ist aus der deutschen Auslegeschrift Nr. 2422123 bereits eine bistabile Verriegelungsschaltung bekannt, bei der die Zeitverzögerung des Ausgangssignals gegenüber dem auslösenden Eingangssignal reduziert ist.

Dabei ist ein Eingangs-Ausgangskreis vorgesehen, der aufgrund eines Eingangssignals direkt ein Ausgangssignal liefert. Mit dem Eingangs-Ausgangskreis ist die Verriegelungsschaltung gekoppelt, die aufgrund des Eingangssignals verriegelt und dadurch das Ausgangssignal aufrechterhält.

Nachteilig bei dieser Schaltung ist, dass die Verriegelungsschaltung ständig in Betrieb ist, damit ständig Leistung verbraucht und gleichzeitig mit dem Eingangssignal umgeschaltet werden muss. Diese Umschaltung belastet den Eingangs-Ausgangskreis und bewirkt ebenfalls noch eine unerwünschte Zeitverzögerung.

Es sind auch eine ganze Reihe von Anwendungsgebieten für Phasenteiler bekannt, bei denen dieser zusammengesetzt ist aus einem Echt-Komplement-Generator und einer Verriegelungsschaltung. Man strebt mit dieser Kombination das Ziel an, aufgrund eines Eingangssignals möglichst schnell gegenphasige Ausgangssignale zu erhalten und dann eine Verriegelung zu bewirken, so dass der eingestellte Schaltzustand auch bei Abschalten des Eingangssignals oder sogar noch bei nachfolgendem Zuschalten eines zum ersten komplementären zweiten Eingangssignals erhalten bleibt.

Hervorzuheben sind Anwendungsgebiete, wie verriegelnde Pufferschaltungen und verriegelnde Leseschaltungen für Halbleiterspeicheranordnungen. Pufferschaltungen sind beispielsweise im «IBM Technical Disclosure Bulletin» Vol. 20, Nr. 4, September 1977, Seiten 1426-1429 und im «IBM Technical Disclosure Bulletin», Vol. 18, Nr. 11, April 1976, Seiten 3597 und 3598 veröffentlicht. Diese Schaltungen enthalten neben einem Echt-Komplement-Generator eine Verriegelungsschaltung, in der die vom Echt-Komplement-Generator gelieferten Signale auch nach Ende des auslösenden Eingangssignals des Echt-Komplement-Generators gespeichert bleiben und zur Weiterverwendung bereitgehalten werden.

Nachteilig bei der Schaltung der erstgenannten Veröffentlichung ist, dass das Ausgangssignal erst nach Ablauf des Verriegelungsvorganges zur Verfügung steht und dass eine aufwendige Taktierung der Schaltung erforderlich ist. Auch bei der in der an zweiter Stelle genannten Veröffentlichung gezeigten Schaltung ergeben sich zeitliche Verzögerungen dadurch, dass die Ausgangssignale durch den Verriegelungsvorgang beeinflusst werden, da die Verriegelungsschaltung parallel an die Ausgänge des Echt-Komplement-Generators angeschaltet ist.

Entsprechende Nachteile sind auch den im «IBM Technical Disclosure Bulletin», Vol. 20, Nr. 1B, Juni 1981, Seiten 534 und 535 und in der deutschen Offenlegungsschrift Nr. 2721851 gezeigten verriegelnden Leseverstärkern zuzuschreiben. Als nachteilig ist hier auch festzustellen, dass die verwendeten Verriegelungsschaltungen in Form von Flipflops ständig aktiv sind, also ständig Strom ziehen und bei einem entsprechenden Schaltvorgang vom einen in den anderen Schaltzustand umzuschalten sind, was zusätzliche Verzögerungen bewirkt.

Hier will die Erfindung Abhilfe schaffen. Die Erfindung, wie sie in dem Anspruch 1 gekennzeichnet ist, löst die Aufgabe, einen Phasenteiler mit integrierter Verriegelungsschaltung zu schaffen, bei dem die aufgrund eines einem Echt-Komplement-Generator zugeführten Eingangssignals gebildeten komplementären Ausgangssignale direkt, ohne Belastung durch die Verriegelungsschaltung zur Verfügung stehen, bei dem bei einer vorzeitigen Änderung des Eingangssignals keine unerwünschte Änderung des zuvor eingestellten Schaltzustandes bzw. der Ausgangssignale erfolgen kann, und bei dem eine unaufwendige Taktierung zur funktionsgerechten Steuerung angewandt werden kann.

Die durch die Erfindung erreichten Vorteile sind im wesentlichen darin zu sehen, dass die Geschwindigkeit, mit der die komplementären Ausgangssignale geliefert werden, extrem hoch ist, da die Ausgangssignale direkt, d.h., mit nur einer Stufenverzögerung zur Verfügung stehen, wobei die Verriegelungsschaltung im Ruhezustand stromlos ist und somit bei einem Verriegelungsvorgang nicht um-, sondern nur eingeschaltet zu werden braucht.

Ein ganz wesentlicher Vorteil erwächst auch aus der Tatsache, dass der Verriegelungsvorgang durch Abschalten des Echt-Komplement-Generators von der Stromversorgung ausgelöst wird, was sowohl die Taktierung der Schaltung vereinfacht als auch den Eingang des Echt-Komplement-Generators für vorzeitige bzw. unerwünschte Änderungen des Eingangssignals inaktiv macht.

Besonders hervorzuheben bleibt die Eigenschaft des erfindungsgemässen Phasenteilers, dass dessen Funktion im wesentlichen mit nur einem Taktsignal sichergestellt werden kann.

Im folgenden wird die Erfindung anhand einer lediglich einen Ausführungsweg darstellenden Zeichnung näher erläutert. Es zeigen:

Fig. 1 das Schaltbild eines erfindungsgemässen Phasenteilers,

Fig. 2 eine schematische Darstellung der Steuerung bzw. Taktierung des erfindungsgemässen Phasenteilers und

Fig. 3 ein die Funktion des erfindungsgemässen Phasenteilers kennzeichnenden Impulsdiagramm.

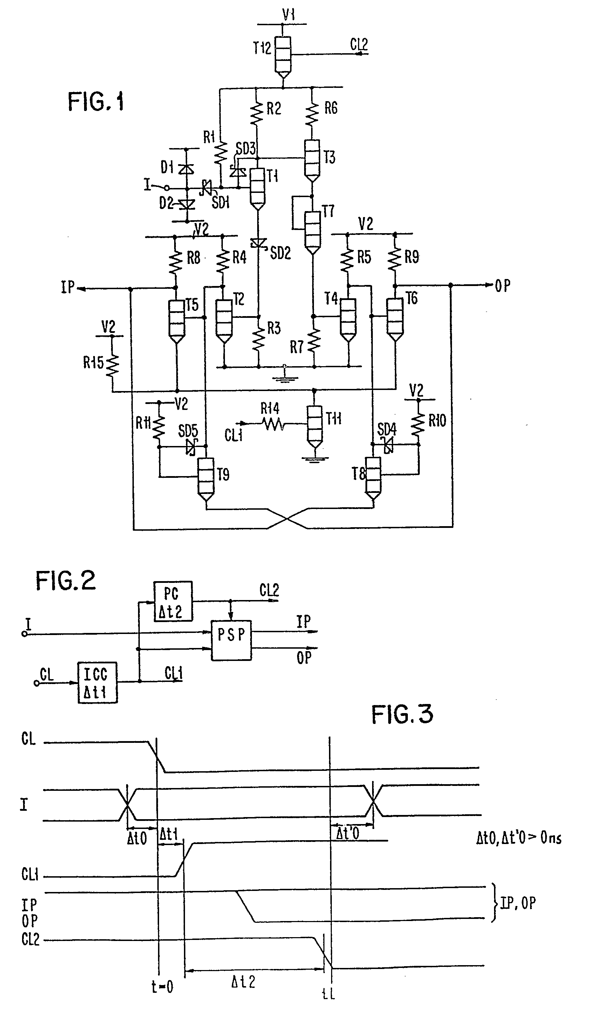

Zunächst sei der schaltungsmässige Aufbau des erfindungsgemässen Phasenteilers betrachtet, wie er in Fig. 1 dargestellt ist.

Der Phasenteiler, der in der schematischen Darstellung nach Fig. 2 mit PSP bezeichnet ist, setzt sich aus drei wesentlichen Grundbestandteilen zusammen. Diese Grundbestandteile sind ein über einen ersten Schalter an eine Stromversorgung angeschlossener Echt-Komplement-Generator, zweier an die Ausgänge des Echt-Komplement-Generators angeschlossener, über einen zweiten Schalter aktivierbarer Ausgangsstufen und einer aus einem jeweils den Ausgang der einen mit dem Eingang der anderen Ausgangsstufe verbindenden Koppelglied bestehenden Verriegelungsschaltung.

Der Echt-Komplement-Generator umfasst zwei hintereinander geschaltete Transistorstufen. Die ersten Transistorstufe enthält einen Transistor T1 mit einem Kollektorlastwiderstand R2 und einem Emitterwiderstand R3. Ausserdem ist zur Basisstromeinstellung ein Widerstand R1 vorgesehen. An die Basis dieses Transistors T1 ist der Eingang I des Echt-Komplement-Generators geführt, wobei im betrachteten Ausführungsbeispiel zwei antiparallel, nach Bezugspotential geführte, pegelbegrenzende Dioden D1 und D2 und eine der Basis vorgeschaltete Schottkydiode SD1 in den Eingangskreis eingeschaltet sind. Zur Pegelverschiebung bzw. -anpassung ist zusätzlich eine Schottkydiode SD2 im Emitterkreis des Transistors T1 vorgesehen. Zwischen Kollektor und Basis liegt eine sättigungsverhindernde Schottkydiode SD3.

Der Kollektorausgang der ersten Transistorstufe ist mit der Basis eines die zweite Transistorstufe des Echt-Komplement-Generators bildenden Transistors T3 verbunden. Diese Transistorstufe enthält einen Kollektorlastwiderstand R6, einen Emitterwiderstand R7 und im betrachteten Ausführungsbeispiel einen zusätzlichen, als Diode geschalteten Transistor T7 im Emitterkreis. Die Emitterwiderstände R3 und R7 der beiden Transistorstufen sind gemeinsam an Bezugspotential geführt, während die Kollektorlastwiderstände R2 und R6 über die Emitter-Kollektorstrecke eines den ersten Schalter bildenden Transistors T12 an eine Spannungsquelle V1 geführt sind, die die Stromversorgung des Echt-Komplement-Generators sicherstellt. Dieser erste Schalter T12 ist über ein Taktsignal CL2 an der Basis des Transistors T12 steuerbar. Die Emitterausgänge der beiden Transistorstufen sind jeweils mit der Basis eines weiteren, in Emitterschaltung betriebenen Transistors T2 und T4 mit den Kollektorlastwiderständen R4 und R5 verbunden. Die Kollektorausgänge dieser beiden Transistoren T2 und T4 bilden die Ausgänge des Echt-Komplement-Generators.

Die genannten Ausgangsstufen umfassen jeweils einen Transistor T5 bzw. T6 mit den Kollektorlastwiderständen R8 bzw. R9, die an eine Spannungsquelle V2 geführt sind, über die auch die Stromversorgung der Transistoren T2 und T4 erfolgt. Die Emitter dieser beiden Transistoren T5 und T6 sind gemeinsam einmal über die Kollektor-Emitterstrecke eines den genannten zweiten Schalter bildenden Transistors T11 mit Bezugspotential und über einen Widerstand R15 mit der Betriebsspannung V2 verbunden. Die Steuerung des Schalters erfolgt über ein Taktsignal CL1, das über einen Widerstand R14 an die Basis des Transistors T11 anlegbar ist. Die Kollektorausgänge der die beiden Ausgangsstufen bildenden Transistoren T5 und T6 bilden die beiden gegenphasigen Ausgänge IP und OP des Phasenteilers.

Die den dritten Grundbestandteil des Phasenteilers bildende Verriegelungsschaltung umfasst im wesentlichen zwei Transistoren T8 und T9, die aktive Koppelglieder bilden und jeweils den Ausgang der einen mit dem Eingang der anderen Ausgangsstufe T5, T6 verbinden. Dabei liegt der Kollektor des Transistors T8 an der Basis des Transistors T6, während der Emitter mit dem Ausgang IP des Phasenteilers verbunden ist. Der Kollektor des Transistors T9 liegt an der Basis des Transistors T5, während der Emitter mit dem Ausgang OP des Phasenteilers verbunden ist. Die Basen dieser beiden Transistoren T8 und T9 sind jeweils über einen Widerstand R10 bzw. R11 mit der Betriebsspannung V2 verbunden. Zwischen Basis und Kollektor ist jeweils eine Schottkydiode SD4, SD5 eingeschaltet, die verhindert, dass der zugehörige Transistor in inverser Richtung stromführend werden könnte.

Über diese beiden Koppelglieder erfolgt die angestrebte Verriegelung des Phasenteilers.

Es sei nunmehr die Wirkungsweise des erfindungsgemässen Phasenteilers, der in Fig. 2 als Block PSP dargestellt ist, anhand der Fig. 1 in Verbindung mit der die taktmässige Steuerung und das zugehörige Impulsdiagramm wiedergebenden Fig. 2 und 3 beschrieben.

Wesentlich ist, und das ist klar den Fig. 2 und 3 zu entnehmen, dass zur Steuerung des erfindungsgemässen Phasenteilers lediglich ein externes Taktsignal CL zuzuführen ist, von dem dann auf dem Halbleiterplättchen selbst, auf dem der Phasenteiler integriert ist, zwei weitere Taktsignale CL1 und CL2 abgeleitet werden. Diese abgeleiteten Taktsignale sind gegenüber dem externen Taktsignal CL etwas zeitverzögert. Die Verzögerung $\Delta t1$ des vom externen Taktsignal CL abgeleiteten Taktsignals CL1 wird in einer vorhandenen, nicht dargestellten Eingangs-Steuerschaltung ICC bewirkt. Die Verzögerung $\Delta t2$ des vom Taktsignal CL1 abgeleiteten Taktsignals CL2 erfolgt in der ebenfalls nicht dargestellten Stromversorgungsschaltung PC des Phasenteilers PSP. In einem praktischen Ausführungsbeispiel kann $\Delta t1$ etwa 2 ns und $\Delta t2$ etwa 5 ns betragen. Mit dem Taktsignal CL1 wird der zweite Schalter (Transistor T11) geschlossen, wodurch die Ausgangsstufen (Transistoren T5 und T6) aktiviert werden. Mit Hilfe des Taktsignales CL2 wird der erste Schalter (Transistor T12) geschlossen, wodurch der Echt-Komplement-Generator (Transistoren T1 bis T4) an die Stromversorgung (Betriebspotential V1) angeschlossen wird. Eine sichere Operation ist gewährleistet, da $\Delta t2$ erst beginnt, wenn $\Delta t1$ abgelaufen ist.

Im Ruhezustand der Schaltung liegen die Verhältnisse vor, wie sie im Impulsdiagramm der Fig. 3 links vom Zeitpunkt t = 0 gekennzeichnet sind. Der externe Taktimpuls CL nimmt den oberen Pegelwert ein, was bedeutet, dass das davon abgeleitete Taktsignal CL1 den unteren Pegelwert aufweist und dass damit der zweite Schalter geöffnet, d.h., der Transistor T11 gesperrt ist. Bei geöffnetem zweiten Schalter sind die beiden Ausgangsstufen (T5, T6) stromlos. Das Taktsignal CL2 nimmt den oberen Pegelwert ein, was bedeutet, dass der erste Schalter geschlossen, d.h. der Transistor T12 leitend ist. Bei geschlossenem ersten Schalter ist der Echt-Komplement-Generator (T1 bis T4) an die Stromversorgung angeschlossen.

Die Tatsache, dass der Echt-Komplement-Generator bereits im Ruhezustand der Schaltung aktiviert ist, hat den Vorteil, dass er zu Beginn einer Selektionsphase nicht erst aktiviert zu werden braucht. Der damit verbundene Leistungsverbrauch im Ruhezustand ist extrem gering. Da beide Transistoren T5 und T6 der Ausgangsstufen nichtleitend sind, sind auch die die beiden Koppelglieder bildenden Transistoren T9 und T8 nichtleitend.

Es sei nun die Selektionsphase betrachtet, die zum Zeitpunkt t = 0 (Fig. 3) mit dem Abfall des auslösenden externen Taktsignals CL auf dem unteren Pegelwert beginnt. Voraussetzung für einen korrekten Funktionsablauf ist lediglich, dass das Eingangssignal I zu Beginn der Selektion bereits gültig ist ($\Delta t0 > 0$). Da der Echt-Komplement-Generator (Transistoren T1 bis T4) bereits aktiviert ist, liefert er an die Basen der Transistoren T5 und T6 der Ausgangsstufen bereits ein gültiges Signal, sobald nach einer Verzögerung von $\Delta t1$ das Taktsignal CL1 vom unteren auf den oberen Pegel umschaltet, damit den zweiten Schalter (Transistor T11) schliesst und die beiden Ausgangsstufen (T5, T6) aktiviert. Dadurch werden an den Ausgängen IP und OP die dem Eingangssignal entsprechenden komplementären Signale erzeugt. Die am Eingang I zugeführte Information muss also nur eine Schaltstufe durchlaufen, um gültig am Ausgang IP und OP des Phasenteilers verfügbar zu sein. Gleichzeitig mit dem Einschalten der Transistoren T5 oder T6 der Ausgangsstufen wird die interne Latch-Funktion aktiviert. Dies geschieht aber erst, wenn aufgrund des um die Zeit $\Delta t2$ verzögert abfallenden Taktsignals CL2 der Echt-Komplement-Generator über den ersten Schalter (T12) von der Stromversorgung V1 abgeschaltet wird. Die Transistoren T2 und T4 werden dabei stromlos und die am Eingang I anliegende Information wird über die Koppelglieder (T8, T9) fest im Phasenteiler gespeichert. Bei diesem Verriegelungsvorgang muss, da beide Koppelglieder (T8, T9) zunächst stromlos sind, keine Umschaltung vorgenommen werden, sondern es wird lediglich eines der Koppelglieder in den leitenden Zustand gebracht. Dass der Verriegelungsvorgang über den ersten Schalter (T12) durch Abschalten der Stromversorgung für den Echt-Komplement-Generator erfolgt, bewirkt, dass bei einer späteren, ungewollten Änderung des Eingangssignals die eingestellten Ausgangssignale erhalten bleiben. Der Verriegelungsvorgang erfolgt zum Zeitpunkt tL, bei dem der erste Schalter (T12) geöffnet wird.

Liegt am Eingang I der Schaltung ein oberer Signalpegel entsprechend einer binären 1, so sind die Transistoren T1 und T2 eingeschaltet und am Kollektor des Transistors T2 liegt ein unterer Pegelwert. Die Basis des Transistors T3 wird auf einen unteren Pegelwert von $2 \cdot V_{BE}$ über Bezugspotential gezogen, so dass die Spannung an der Basis des Transistors T4 nur wenige Millivolt beträgt. Dadurch wird der Transistor T4 im Aus-Zustand gehalten. Im Vergleich zur Spannung am Kollektor des Transistors T2 liegt jetzt am Kollektor von Transistor T4 die komplementäre Information (oberer Pegelwert).

Liegt ein einer binären 0 entsprechender Signalpegel am Eingang I der Schaltung, so sind die Transistoren T1 und T2 gesperrt, und die Transistoren T3, T4 und T7 leitend. Die Kollektorspannungen der Transistoren T2 und T4 sind entsprechend umgekehrt.

Selbstverständlich muss das Eingangssignal I etwas über den Zeitpunkt tL hinaus ($\Delta t'0 > 0$) am Eingang vorhanden sein, bis der Verriegelungsvorgang eingeleitet bzw. abgeschlossen ist. Um die Schaltgeschwindigkeit des Phasenteilers möglichst unabhängig von einer externen Versorgungsspannung und Temperatureinflüssen zu machen, wird eine auf dem Halbleiterchip integrierte Stromversorgungsschaltung PC verwendet.

Als besonders vorteilhaft erweist es sich, dass die Ausgangsstufen (T5, T6) sofort mit dem ersten internen Taktsignal CL1 eingeschaltet werden, da der leistungsarme Echt-Komplement-Generator schon zu Beginn des Zyklus die Basen der Transistoren T5 und T6 mit der korrekten Information versorgt. Dadurch liefern die Ausgänge IP und OP sehr schnell korrekte und störungsfreie Signale.

Schon wenige Nanosekunden später kann der Echt-Komplement-Generator, der die beiden Ausgangsstufen (T5, T6) steuert, über das Taktsignal ICL2 abgeschaltet werden, wodurch die am Eingang I liegende Information fest in den Phasenteiler eingespeichert wird. Die Schaltung ist im Vergleich zu ihrem Leistungsverbrauch sehr schnell. Sie erfordert neben einem einzigen Taktsignal CL keine weiteren Hilfssignale, deren Funktionen und Toleranzen das Ausgangssignal verzögern.

**Patentansprüche**

1. Phasenteiler mit integrierter Verriegelungsschaltung, enthaltend einen über einen ersten taktgesteuerten Schalter (T12) an eine Stromversorgung angeschlossenen und in Abhängigkeit von einem Eingangssignal (I) komplementäre Ausgangssignale liefernden Echt-Komplement-Generator (T1, T3), an dessen Ausgänge jeweils eine gesonderte Ausgangsstufe (T5, T6) mit Ausgängen (IP, OP) angeschlossen ist, dadurch gekennzeichnet, dass die Ausgangsstufen (T5, T6) des Echt-Komplement-Generators (T1 bis T4) über einen zweiten taktgesteuerten Schalter (T11) aktivierbar sind und dass jeweils der Ausgang der einen mit dem Eingang der anderen Ausgangsstufe (T5, T6) über ein aktives Koppelglied (T8, T9) verbunden ist, so dass bei Anliegen des Eingangssignals (I) und geschlossenem ersten Schalter (T12) durch Schliessen des zweiten Schalters (T11) eine der Ausgangsstufen (T5, T6) und durch anschliessendes Öffnen des ersten Schalters (T12) eines der die Verriegelung bewirkenden Koppelglieder (T8, T9) leitend wird.

2. Phasenteiler nach Anspruch 1, dadurch gekennzeichnet, dass jede Ausgangsstufe einen Transistor (T5, T6) in Emitterschaltung umfasst und dass die Emitter dieser beiden Transistoren über eine im gemeinsamen Emitterkreis liegende Kollektor-Emitterstrecke eines als zweiter Schalter dienenden, an seiner Basis gesteuerten Transistors (T11) an ein Bezugspotential geführt sind.

3. Phasenteiler nach Anspruch 1 oder 2, dadurch gekennzeichnet, dass jedes der beiden aktiven Koppelglieder der Verriegelungsschaltung aus der die Basis des Transistors (T5, T6) der einen Ausgangsstufe mit dem Kollektorausgang des Transistors der anderen Ausgangsstufe verbindenden Kollektor-Emitterstrecke eines Transistors (T8, T9) besteht, dessen Basis an ein Betriebspotential (V2) angeschlossen ist.

4. Phasenteiler nach den Ansprüchen 1 bis 3, dadurch gekennzeichnet, dass der Echt-Komplement-Generator aus zwei hintereinander geschalteten Transistorstufen besteht, wobei der Kollektorausgang des einen (T1) mit der Basis des anderen Transistors (T3) gekoppelt ist und die Emitterausgänge über jeweils eine weitere Transistorstufe (T2, T4) in Emitterschaltung auf den Eingang der zugehörigen Ausgangsstufe (T5, T6) geführt sind.

5. Phasenteiler nach Anspruch 4, dadurch gekennzeichnet, dass der erste Schalter (T12), aus der die beiden Kollektorlastelemente (R2, R6) der beiden den Echt-Komplement-Generator bildenden Transistoren (T1, T3) mit einem Betriebspotential (V1) verbindenden Kollektor-Emitterstrecke eines an seiner Basis gesteuerten Transistors (T12) besteht.

**Claims**

1. Phase splitter with integrated latch circuits, comprising a true-complement generator (T1, T3) connected via a first clock-controlled switch (T12) to a current supply, and supplying complementary output signals as a function of an input signal (I), one separate output stage (T5, T6) with outputs (IP, OP) being respectively connected to the outputs of the true-complement generator, characterized in that the output stages (T5, T6) of the true-complement generator (T1 to T4) are activatable via a second clock controlled switch (T11), and that the output of the one is respectively connected to the input of the other output stage (T5, T6) via an active coupling stage (T8, T9) so that if the input signal (I) is applied and the first switch (T12) is switched on, one of the output stages (T5, T6) is rendered conductive by the switching-on of the second switch (T11), and by the subsequent switching-off of the first switch (T12) one of the coupling stages (T8, T9) effecting the latching process is rendered conductive.

2. Phase splitter as claimed in Claim 1, characterized in that each output stage comprises a transistor (T5, T6) in emitter configuration, and that the emitters of these two transistors are applied to a reference potential via a collector-emitter path in the jointly used emitter circuit, of a transistor (T11) used as a second switch and controlled at its base.

3. Phase splitter as claimed in Claim 1 or 2, characterized in that each of the two active coupling stages of the latch circuit consists of the collector emitter path connecting the base of the transistor (T5, T6) of the one output stage to the collector output of the transistor of the other output stage, of a transistor (T8, T9) whose base is connected to a reference potential (V2).

4. Phase splitter as claimed in any one of Claims 1 to 3, characterized in that the true-complement generator consists of two series-arranged transistor stages, the collector output of the one (T1) being coupled to the base of the other transistor (T3), and the emitter outputs being applied via one respective further transistor stage (T2, T4) in emitter configuration to the input of the associated output stage (T5, T6).

5. Phase splitter as claimed in Claim 4, characterized in that the first switch (T12) consists of the collector emitter path connecting the two collector load elements (R2, R6) of the two transistors (T1, T3) forming the true-complement generator to a reference potential (V1), of a transistor (T12) controlled at its base.

## Revendications

1. Diviseur de phase comportant un circuit de verrouillage intégré, contenant un générateur de compléments réels (T1, T3), raccordé à une alimentation en courant par l'intermédiaire d'un premier commutateur (T12) commandé de façon cadencée, et délivrant des signaux de sortie complémentaires en fonction d'un signal d'entrée (I) et aux sorties duquel se trouve raccordé respectivement un étage de sortie particulier (T5, T6) comportant des sorties (IP, OP), caractérisé en ce que les étages de sortie (T5, T6) du générateur de compléments réels (T1 à T4) peuvent être activés par l'intermédiaire d'un second commutateur (T11) commandé de façon cadencée et que respectivement la sortie d'un étage de sortie (T5, T6) est reliée à l'entrée de l'autre étage de sortie (S1, S6) par l'intermédiaire d'un circuit de couplage actif (T8, T9), de sorte que lors de l'application du signal d'entrée (I) et lorsque le premier commutateur (T12) est fermé, l'un des étages de sortie (T5, T6) est placé à l'état conducteur par suite de la fermeture du second commutateur (T11) et l'un des circuits de couplage (T8, T9) réalisant le verrouillage est placé à l'état conducteur par suite de l'ouverture ultérieure du premier commutateur (T12).

2. Diviseur de phase selon la revendication 1, caractérisé en ce que chaque étage de sortie contient un transistor (T5, T6) monté en émetteur commun et que les émetteurs de ces deux transistors sont raccordés à un potentiel de référence par l'intermédiaire d'une voie collecteur-émetteur située dans le circuit d'émetteur commun, d'un transistor (T11) utilisé en tant que second commutateur et commandé par sa base.

3. Diviseur de phase selon la revendication 1 ou 2, caractérisé en ce que chacun des deux circuits de couplage actifs du circuit de verrouillage est constitué par la voie collecteur-émetteur, reliant la base du transistor (T5, T6) d'un étage de sortie à la sortie du collecteur du transistor de l'autre étage de sortie, d'un transistor (T8, T9), dont la base est placée à un potentiel de service (V2).

4. Diviseur de phase selon les revendications 1 à 3, caractérisé en ce que le générateur de compléments réels est constitué par deux étages à transistors branchés en série, la sortie du collecteur d'un transistor (T1) étant accouplée à la base de l'autre transistor (T3) et les sorties d'émetteur étant reliées par l'intermédiaire respectivement d'un autre étage à transistors (T2, T4) monté en émetteur commun, à l'entrée de l'étage de sortie (T5, T6) associé.

5. Diviseur de phase selon la revendication 4, caractérisé en ce que le premier commutateur (T12) est constitué par la voie collecteur-émetteur, reliant les deux éléments de charge de collecteur (R2, R6) des deux transistors (T1, T3) constituant le générateur de compléments réels à un potentiel de service (V1), d'un transistor (T12) commandé sur sa base.

FIG.1

FIG.2

FIG.3